# EUROPEAN PATENT SPECIFICATION

(11) **EP 2 682 720 B1**
(45) Date of publication and mention of the grant of the patent: **18.09.2019**
(21) Application number: 11859960.4
(22) Date of filing: 02.03.2011
(51) Int. Cl.: G01F 1/692, G01F 1/684, G01F 5/00, H01L 29/66

(54) **HEAT-TYPE FLOW METER**
WÄRMEDURCHFLUSSMESSER
DÉBITMÈTRE DU TYPE THERMIQUE

(43) Date of publication of application: 08.01.2014
(73) Proprietor: Hitachi Automotive Systems, Ltd., Hitachinaka-shi Ibaraki 312-8503 (JP)
(72) Inventor: NAKANO, Hiroshi, Hitachi-shi, Ibaraki 319-1292 (JP); MATSUMOTO, Masahiro, Hitachi-shi, Ibaraki 319-1292 (JP); ASANO, Satoshi, Hitachi-shi, Ibaraki 319-1292 (JP); HANZAWA, Keiji, Hitachinaka-shi, Ibaraki 312-0062 (JP)
(74) Representative: MERH-IP Matias Erny Reichl Hoffmann Patentanwälte PartG mbB
(86) International application number: PCT/JP2011/001197
(87) International publication number: WO 2012/117446

(56) References cited:
- EP-A2- 1 348 937
- WO-A1-01/84088
- JP-A- 2 120 624
- JP-A- 61 170 618
- JP-A- 2002 286 521
- JP-A- 2002 286 521
- JP-A- 2003 075 222
- JP-A- 2005 321 294
- JP-A- 2010 160 092
- US-A1- 2004 118 202

## Description

### Technical Field

The present invention relates to a thermal type flowmeter that measures a flow by a heating resistor body installed in a fluid to be measured, and in particular, to a compact thermal type flowmeter that is suitable for measuring an exhaust gas flow and an intake air flow of an internal combustion engine of an automobile.

### Background Art

A thermal type air flowmeter capable of directly measuring a mass flow is mainly used as an air flowmeter that detects an intake air amount of an internal combustion engine of an automobile or the like.

Recently proposed is a thermal type air flowmeter in which a sensor element thereof is manufactured on a semiconductor substrate of silicon (Si) or the like by using MEMS technology. In such a semiconductor type sensor element, a hollow portion is formed by removing a rectangular portion of a semiconductor substrate, and a heating resistor body is formed on an electrical insulating film of several microns formed in the hollow portion. By forming a pair of temperature sensors (temperature-sensing resistor bodies) at an upstream side and a downstream side in the vicinity of the heating resistor body, a flow can be detected from a temperature difference between the upstream side and the downstream side of the heating resistor body which is caused by an air flow. Also, according to this method, a forward flow and a reverse flow can be determined. Also, since the size of the heating resistor body is as minute as several hundred micrometers and is formed in the shape of a thin film, the heating resistor body has a small thermal capacity and can implement fast response, low power consumption and compactness.

The technology related to the compactness of a sensor element is described in PTL 1 and PTL 2. In PTL 1, a semiconductor sensor element, a control circuit chip, and a terminal material are integrated by molding, thereby promoting component count reduction and low cost. Also, in PTL 2, a plurality of heating resistor elements, a temperature detector element, and a control circuit are integrally formed on a chip, thereby promoting compactness.

The integration of a sensor element and a control circuit on the same semiconductor substrate as in PTL 2 can be implemented because the sensor element is a MEMS that is manufactured by using a semiconductor process. However, in a process of manufacturing a sensor element of a thermal type flowmeter, in order to provide a good property of a resistor body formed in the sensor element, an annealing process is performed to thermally treat the resistor body placed in a high-temperature furnace body in a wafer state. Therefore, when a sensor element and a semiconductor integrated circuit are integrated, the sensor element and the semiconductor integrated circuit are simultaneously exposed to a high temperature. Since a MOS (Metal Oxide Semiconductor) transistor is used in most semiconductor integrated circuits, the MOS transistor is exposed to a high temperature for a long time, thereby causing property variation and malfunction.

In this case, required is a partial annealing method that confines an annealing region to a region in which the sensor element is formed. For example, as described in PTL 3, there is a local annealing method that energizes and heats a gate electrode of a field-effect transistor and anneals a doped region of the field-effect transistor by the heat.

### Citation List

### Patent Literature

PTL 1: JP 11-6752 A
PTL 2: JP 8-29224 A
PTL 3: JP 11-26391 A

EP 1 348 937 A2 describes a gas flowmeter that comprises a silicon semiconductor substrate 2 formed with a cavity 9 and a heat element 4 formed above the cavity 9 of the semiconductor substrate 2 by way of an insulating film.

US 2004/118202 A1 describes a flow sensor that includes a thin film portion. The thin film portion has a heater and a detector for detecting temperature around the heater. The heater is made of a semiconductor.

JP 2002/286521 A describes that an under insulation film is formed on a semiconductor substrate. A conductive film is formed on the film. The film is etched to form a heating resistor, a resistor for flow detection, resistors and for fluid temperature detection, and the lead parts of these resistors.

### Summary of Invention

### Technical Problem

However, in addition to semiconductor materials such as doped monocrystalline silicon and doped polycrystalline silicon, metal materials such as platinum, tungsten, tantalum, and molybdenum are used as materials for the resistor body formed in the sensor element. For example, in the case of polycrystalline silicon doped with a dopant such as phosphorus, a long-time high-temperature thermal treatment is required to thermally diffuse the dopant. Also, in the case of platinum and molybdenum as metal materials, in order to grow a crystal grain, an annealing treatment needs to be performed at a temperature of 800°C to 1000°C for several minutes after film formation.

In the case of energizing and partially heating an electrode formed in an annealing region by using a technique described in PTL 3, when long-time high-temperature heating is performed for an annealing treatment, not only the annealing region but also the periphery thereof and a portion in which a semiconductor integrated circuit is formed are heated to a high temperature by thermal conduction, thus causing the malfunction and the property variation of the semiconductor integrated circuit. Therefore, in an integrated structure of the sensor element and the semiconductor integrated circuit, the technique described in PTL 3 is insufficient to partially anneal a sensor element portion.

Therefore, in order to solve the above problem, an object of the invention is to provide a compact thermal type flowmeter that can perform a partial thermal treatment on a sensor element portion without affecting other elements and can improve the reliability of a sensor element while improving the sensitivity of the sensor element.

### Solution to Problem

The problem is solved by the invention according to the independent claims. The dependent claims described preferred further developments. In order to achieve the above object, the thermal type flowmeter of the invention includes a hollow portion which is formed in a semiconductor substrate, a thin film portion which is formed by insulating films provided to cover the hollow portion, and a heating resistor body and a temperature-measuring resistor body which are formed between the insulating films, wherein a thermal treatment heater is provided under the heating resistor body and a thermal treatment is performed to grow a crystal grain size of the heating resistor body and a crystal grain size of the temperature-measuring resistor body by heating the thin film portion after forming the thin film portion. by energizing the thermal treatment heater.

### Advantageous Effects of Invention

According to the invention, it is possible to provide a compact thermal type flowmeter that can perform a partial thermal treatment on a sensor element portion without affecting other elements and can improve the reliability of a sensor element while improving the sensitivity of the sensor element.

### Brief Description of Drawings

FIG. 1 is a plan view of a sensor element according to a first example which is useful for understanding the invention.
FIG. 2 is a cross-sectional view of the sensor element according to the first example.
FIG. 3 is a circuit diagram illustrating a driving/detecting circuit according to the first example.
FIG. 4 is a view illustrating an example of the installation of the sensor element according to the first example.
FIG. 5 is a view illustrating a process for manufacturing the sensor element according to the first example.
FIG. 6 is an enlarged view of a diaphragm of the sensor element according to the first example.
FIG. 7 is a diagram illustrating a change in the resistance temperature coefficient of a polycrystalline Si thin film.
FIG. 8 is a diagram illustrating a change in the specific resistance of the polycrystalline Si thin film.
FIG. 9 is a plan view of a sensor element according to a second example.
FIG. 10 is a cross-sectional view of the sensor element according to the second example.
FIG. 11 is a cross-sectional view of a sensor element according to the embodiment of the invention.
FIG. 12 is a cross-sectional view of a sensor element according to a third example.
FIG. 13 is a diagram illustrating an energization method according to the first example.
FIG. 14 is a cross-sectional view illustrating the molding of the sensor element according to the third example.
FIG. 15 is a cross-sectional view illustrating the crystalline states of a heating resistor body and an interconnection portion after thermal treatment.

### Description of examples and the embodiment

Hereinafter, examples and the embodiment of the invention will be described.

### First Example

A first example which is useful for understanding the invention of the invention will be described below.

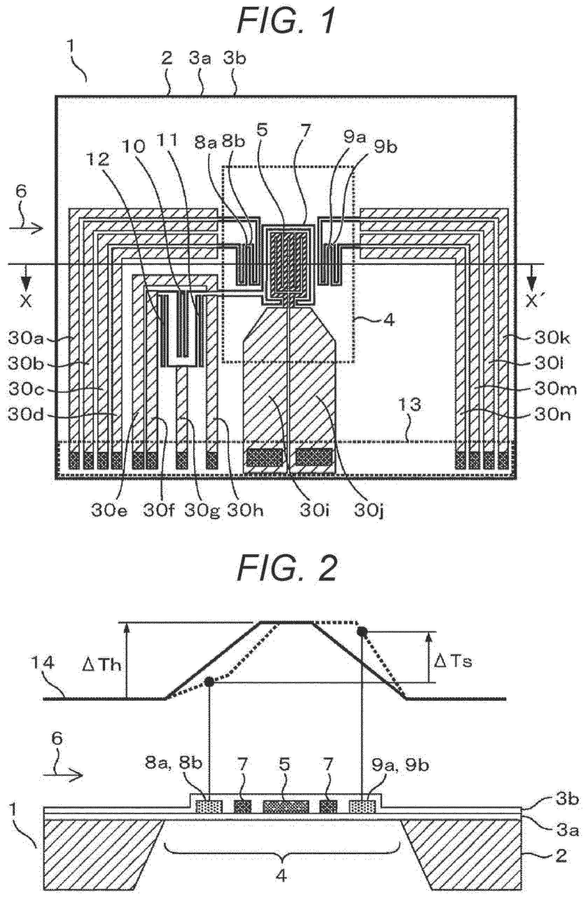

A configuration of a sensor element 1 of a thermal type flowmeter according to this example will be described with reference to FIGS. 1 and 2. FIG. 1 is a plan view of the sensor element 1. Also, FIG. 2 is a cross-sectional view taken along a line X-X' in FIG. 1. A substrate 2 of the sensor element 1 is constructed of a material with a high thermal conductivity, such as silicon and ceramic. An electrical insulating film 3a is formed on the substrate 2, and a diaphragm 4 is formed by forming a hollow portion by etching the substrate 2 from the back side.

A heating resistor body 5 is formed on a surface near the center of the electrical insulating film 3a on the diaphragm 4. A heating temperature sensor 7 detecting a heating temperature of the heating resistor body 5 is formed around the heating resistor body 5 to surround the heating resistor body 5. The temperature of the heating resistor body 5 is detected by the heating temperature sensor 7, and the heating resistor body 5 is heated and controlled such that the temperature of the heating resistor body 5 is higher than the temperature of an air flow 6 by a predetermined temperature. Also, upstream side temperature sensors 8a and 8b and downstream side temperature sensors 9a and 9b are formed on both sides of the heating temperature sensor 7. The upstream side temperature sensors 8a and 8b are disposed on the upstream side of the heating resistor body 5, and the downstream side temperature sensors 9a and 9b are disposed on the downstream side of the heating resistor body 5. The outermost surface of the sensor element 1 is covered by an electrical insulating film 3b. In addition to performing electrical insulation, the electrical insulating film 3b serves as a protection film. Temperature-sensing resistor bodies 10, 11 and 12 having a resistance value changing according to the temperature of the air flow 6 are disposed on the electrical insulating film 3a outside the diaphragm 4.

The heating resistor body 5, the heating temperature sensor 7, the upstream side temperature sensors 8a and 8b, the downstream side temperature sensors 9a and 9b, and the temperature-sensing resistor bodies 10, 11 and 12 are formed of materials having relatively great resistance temperature coefficients, which have resistance values changing according to the temperature. For example, the heating resistor body 5, the heating temperature sensor 7, the upstream side temperature sensors 8a and 8b, the downstream side temperature sensors 9a and 9b, and the temperature-sensing resistor bodies 10, 11 and 12 may be formed of semiconductor materials such as doped monocrystalline silicon and doped polycrystalline silicon, and metal materials such as platinum, molybdenum, tungsten, and nickel alloy. Also, the electrical insulating films 3a and 3b are formed of silicon dioxide (SiO₂) and silicon nitride (Si₃N₄) into a thin film having a thickness of about 2 microns, and have a structure capable of obtaining a sufficient thermal insulation effect.

As described above, like the temperature-sensing resistor bodies 10, 11 and 12, the heating resistor body 5, the heating temperature sensor 7, the upstream side temperature sensors 8a and 8b, and the downstream side temperature sensors 9a and 9b are also temperature-sensing resistor bodies.

Also, an electrode pad portion 13 is provided at an end portion of the sensor element 1, and an electrode for connecting each resistor body constituting the heating resistor body 5, the heating temperature sensor 7, the upstream side temperature sensors 8a and 8b, the downstream side temperature sensors 9a and 9b, and the temperature-sensing resistor bodies 10, 11 and 12 to a driving/detecting circuit, is formed in the electrode pad portion 13. Also, the electrode is formed of aluminum and the like.

The thermal type flowmeter according to an embodiment of the invention operates as follows.

A temperature distribution 14 illustrated together with the cross-sectional configuration of the sensor element 1 illustrated in FIG. 2 is the surface temperature distribution of the sensor element 1. A solid line of the temperature distribution 14 represents the temperature distribution of the diaphragm 4 during calm. The heating resistor body 5 is heated to a temperature that is higher than the temperature of the air flow 6 by ΔTh. A broken line of the temperature distribution 14 represents the temperature distribution of the diaphragm 4 when the air flow 6 has occurred. When the air flow 6 has occurred, the upstream side of the heating resistor body 5 is cooled to a lower temperature by the air flow 6. Also, the downstream side of the heating resistor body 5 is heated to a higher temperature because the air heated while passing through the heating resistor body 5 flows through the downstream side of the heating resistor body 5. Therefore, a flow is measured by measuring a temperature difference ΔTs between the upstream side and the downstream side of the heating resistor body 5 by the upstream side temperature sensors 8a and 8b and the downstream side temperature sensors 9a and 9b.

Next, the driving/detecting circuit of the sensor element 1 will be described.

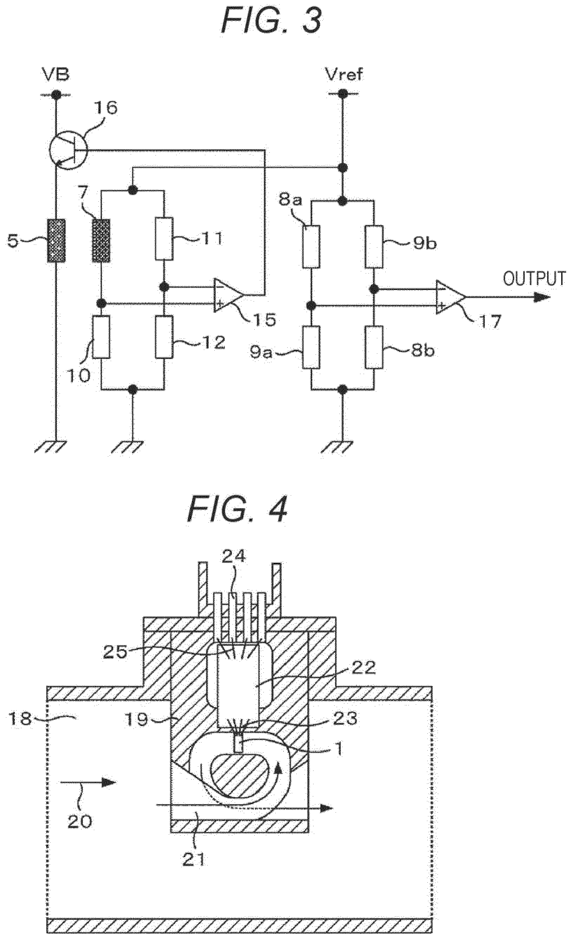

FIG. 3 illustrates the driving/detecting circuit of the sensor element 1. A bridge circuit is constructed by connecting in parallel a serial circuit including the temperature-sensing resistor body 10 and the heating temperature sensor 7 having a resistance value changing according to the temperature of the heating resistor body 5 and a serial circuit including the temperature-sensing resistor body 11 and the temperature-sensing resistor body 12, and a reference voltage Vref is applied to the respective serial circuits. An intermediate voltage of the serial circuits is extracted and connected to an amplifier 15. An output of the amplifier 15 is connected to a base of a transistor 16. A collector of the transistor 16 is connected to a power supply VB, and an emitter of the transistor 16 is connected to the heating resistor body 5 to construct a feedback circuit. Accordingly, the temperature Th of the heating resistor body 5 is controlled to be higher than the temperature Ta of the air flow 6 by a predetermined temperature ΔTh (= Th - Ta).

Also, a bridge circuit is constructed by connecting in parallel a serial circuit including the upstream side temperature sensor 8a and the downstream side temperature sensor 9a and a serial circuit including the downstream side temperature sensor 9b and the upstream side temperature sensor 8b, and the reference voltage Vref is applied to the respective serial circuits. When a temperature difference occurs between the upstream side temperature sensors 8a and 8b and the downstream side temperature sensors 9a and 9b due to the air flow, a voltage difference occurs due to a change in the resistance balance of the bridge circuit. An output corresponding to the air flow is obtained from the voltage difference by an amplifier 17.

Next, FIG. 4 illustrates an example in which the sensor element 1 and the driving/detecting circuit are installed in an intake air pipe line of an internal combustion engine of an automobile or the like. In FIG. 4, a base member 19 is provided to protrude from a wall surface of an intake air pipe line 18. A sub-passage 21 is formed in the base member 19 to introduce a portion of intake air 20 that flows through the intake air pipe line 18. The sensor element 1 is installed in a rectangular concave portion that is formed in the sub-passage 21. In the sub-passage 21 of the portion in which the sensor element 1 is installed, a flow path is linear-shaped and is curved at the upstream side and the downstream side thereof. Also, a circuit board 22 mounted with the driving/detecting circuit of the sensor element 1 is provided in the base member 19, and the sensor element 1 and the circuit board 22 are electrically connected by a gold bonding wire 23. Also, a terminal 24 is provided to extract an output signal and a power supply of the driving circuit, and the circuit board 22 and the terminal 24 are electrically connected by an aluminum bonding wire 25.

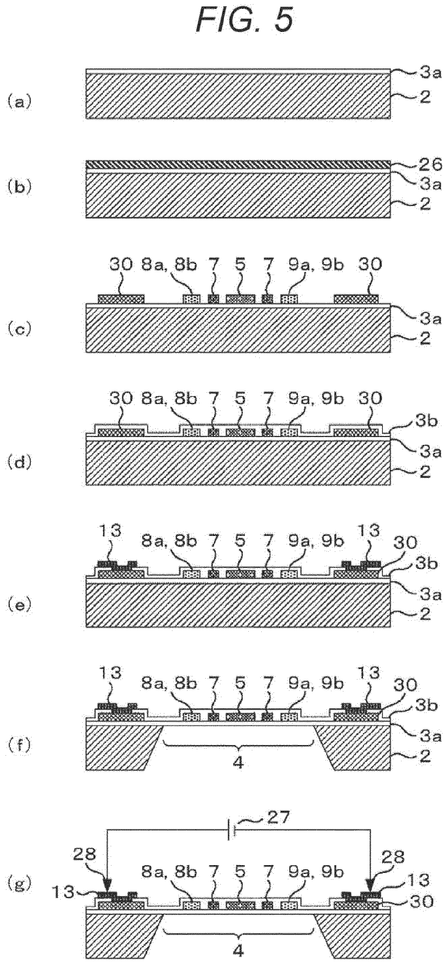

Next, a method for manufacturing the sensor element 1 of the thermal type flowmeter according to this example will be described with reference to FIG. 5.

### [Process of FIG. 5(a)]

A semiconductor substrate of monocrystalline silicon (Si) or the like is used as a substrate 2. On the surface of the substrate 2 serving as a base, an electrical insulating film 3a is formed of silicon dioxide (SiO₂) and silicon nitride (Si₃N₄) to a predetermined thickness of about 1 µm by thermal oxidation, CVD, or the like.

### [Process of FIG. 5(b)]

Next, a semiconductor thin film 26 used as a resistor body and formed of polycrystalline silicon (Si) to a thickness of about 1 µm is stacked by CVD or the like. Dopant diffusion is performed on the polycrystalline silicon (Si) semiconductor thin film, and high-concentration doping is performed to provide a predetermined specific resistance. In the conventional doping/dopant diffusion process, a thermal treatment of injecting a sensor element into a heating furnace of about 900°C to about 1000°C for one hour or more is performed to improve a resistance temperature coefficient of the semiconductor thin film 26, thereby achieving a good property of a resistor body used as a temperature sensor. However, in the case where a MOS (Metal Oxide Semiconductor) transistor is formed as a semiconductor integrated circuit on the substrate 2 in advance (not illustrated), when a thermal treatment of 900°C to 1000°C is performed, a malfunction occurs in the semiconductor integrated circuit due to a property variation of the MOS transistor (for example, expansion of a source/drain region). Therefore, for example, in a CMOS process with a gate length of about 1 µm, a restriction is put to provide a thermal treatment condition in which a property variation of the MOS transistor does not occur at 900°C or less for up to about several minutes. Thus, in this process, the semiconductor thin film 26 is kept in the state of insufficient dopant diffusion and low resistance temperature coefficient. Herein, the thermal treatment condition, in which a property variation of the MOS transistor does not occur, is not uniformly determined but changes according to the degree of miniaturization of semiconductors or the like.

### [Process of FIG. 5(c)]

After a resist is formed into a predetermined shape by photolithography, the polycrystalline silicon (Si) semiconductor thin film is patterned by reactive ion etching or the like, thereby obtaining a predetermined heating resistor body 5, a heating temperature sensor 7, upstream side temperature sensors 8a and 8b, downstream side temperature sensors 9a and 9b, and an interconnection portion 30.

### [Process of FIG. 5(d)]

In a subsequent process, like the electrical insulating film 3a, an electrical insulating film 3b serving as a protection film is formed of silicon dioxide (SiO₂) and silicon nitride (Si₃N₄) to a thickness of about 1 micron by CVD or the like.

### [Process of FIG. 5(e)]

Next, after a portion of the electrical insulating film 3b is removed, an electrode pad portion 13 serving as a terminal for connection with an external circuit is formed of a metal material such as aluminum.

### [Process of FIG. 5(f)]

Next, an etching mask material is patterned into a predetermined shape on the back surface of the monocrystalline silicon (Si) semiconductor substrate 2, and an etchant such as potassium hydroxide (KOH) is used to perform anisotropic etching to form a hollow portion, thereby forming a diaphragm 4.

### [Process of FIG. 5(g)]

Next, a probe 28 is brought into contact with the electrode pad portion 13, and a current is supplied from a power supply 27 through the probe 28. By electrically connecting the interconnection portion 30 to the heating resistor body 5 (not illustrated), the heating resistor body 5 is heated by the current supplied from the power supply 27. At this time, the current of the power supply 27 is adjusted such that the heating temperature sensor 7, the upstream side temperature sensors 8a and 8b, and the downstream side temperature sensors 9a and 9b are heated at 900°C or more (preferably at about 1000°C) for 60 minutes or more.

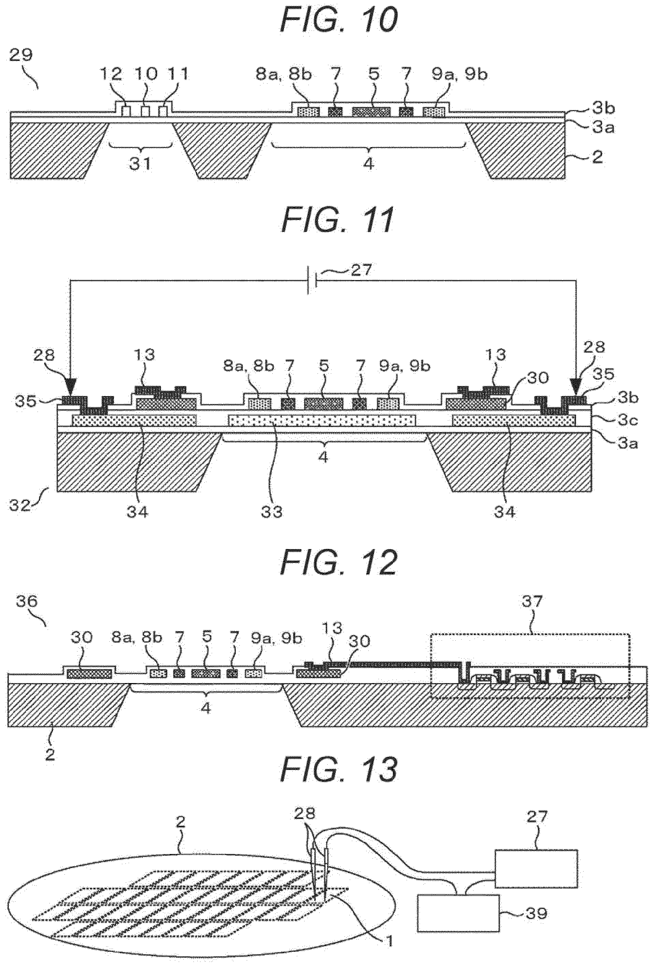

FIG. 13 illustrates a specific energization method. The probe 28 is brought into contact with the sensor element 1 formed in the substrate 2 that is a Si wafer. One side of the probe 28 is connected to the power supply 27, and the other side of the probe 28 is connected through an ammeter 39 to the power supply 27. The power supply 27 is a voltage source, and the heating temperature of the heating resistor body 5 can be adjusted by adjusting a voltage V. The current supply 39 measures a current I flowing through the heating resistor body 5. Since the resistance value of the heating resistor body 5 changes according to the temperature, the temperature of the heating resistor body 5 can be measured by calculating the resistance value (V/I) of the heating resistor body 5 from the voltage V of the power supply 27 and the current I of the ammeter 39. Also, the heating temperature of the heating resistor body 5 can also be calculated from the power consumption (V·I) of the heating resistor body 5. In this case, it is necessary to acquire the relation between the temperature and the power of the heating resistor body 5 in advance. When the heating temperature is calculated from the resistance value of the heating resistor body 5, an error is contained because the resistance value is changed by the thermal treatment. When the heating temperature is calculated from the power consumption, the heating temperature can be more accurately measured because the resistance value is not changed by the thermal treatment.

By the thermal treatment described above, an insufficient thermal treatment can be performed in the process of FIG. 5(b), the dopant diffusion/crystal growth of the resistor bodies of the heating resistor body 5, the heating temperature sensor 7, the upstream side temperature sensors 8a and 8b, and the downstream side temperature sensors 9a and 9b can be performed, and a good property of the resistor body can be obtained by improving the resistance temperature coefficient.

Also, when a current is applied to the heating resistor body 5 in this process, a current also flows through the interconnection 30 and heating occurs. However, since it is located on the substrate 2, heat radiates into the substrate 2 and a temperature increase does not occur. A portion heated above 900°C can be limited to a portion of the diaphragm 4 that is thermally insulated. Therefore, the invention is characterized in that the thermal treatment is performed by energizing the heating resistor body 5 after forming the diaphragm 4.

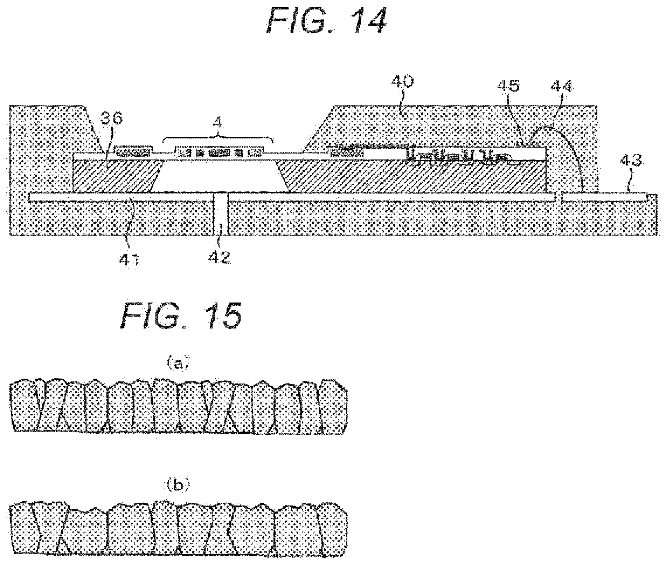

FIG. 15 is a cross-sectional view illustrating the crystalline states of the heating resistor body 5 and the interconnection portion 30 after thermal treatment by this process. FIG. 15(a) is a cross-sectional view of the interconnection portion 30, and FIG. 15 (b) is a cross-sectional view of the heating resistor body 5. Since the heating resistor body 5 thermally-treated by this process is thermally treated at a high temperature, a crystal thereof grows and a crystal grain size thereof increases. On the other hand, since the interconnection portion 30 formed of the same material as the heating resistor body 5 is not thermally treated in this process, a crystal thereof does not grow. Therefore, the crystal grain size is different between the portion that is thermally treated in this process and the portion that is not thermally treated in this process. When the crystal grain size increases, the resistance temperature coefficient increases, so that the temperature detection sensitivity of the temperature-sensing resistor body and the heating resistor body located in the diaphragm 4 can be improved.

Also, since a region on the substrate 2, in which a MOS (Metal Oxide Semiconductor) transistor is formed as a semiconductor integrated circuit, is not heated to a high temperature in advance, the malfunction and the property variation of the MOS transistor do not occur.

By the above processes, the sensor element 1, or the sensor element 1 including the semiconductor integrated circuit is completed.

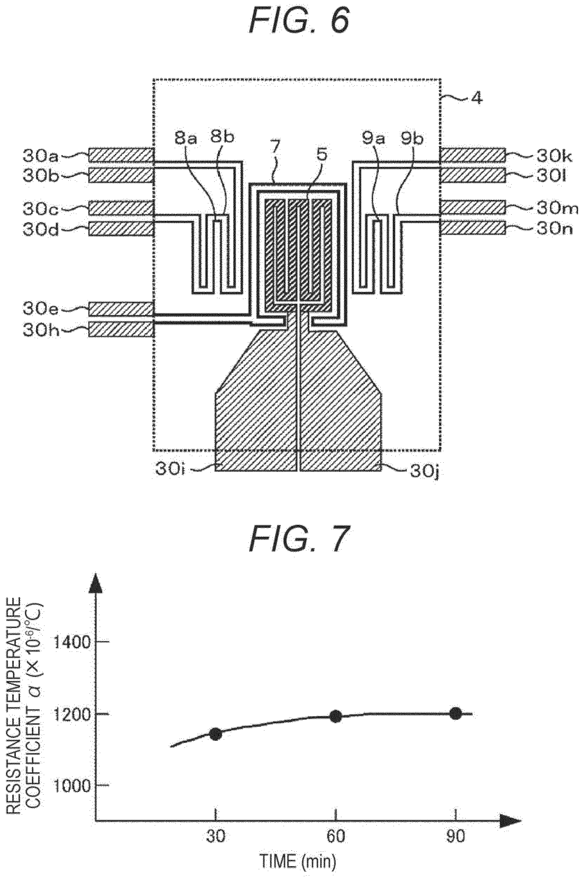

The property of the sensor element 1 manufactured by this example will be described in detail. FIG. 6 is an enlarged view of the diaphragm 4 of the sensor element 1. The heating temperature sensor 7 on the diaphragm 4 is formed to surround the periphery of the heating resistor body 5 . Also, the heating temperature sensor 7 extends toward the upstream side of the diaphragm 4 and is wire-connected to interconnection portions 30e and 30h. The portions from the heating temperature sensor 7 to the interconnection portions 30e and 30h are formed by etching the semiconductor thin film 26 formed by the process of FIG. 5(b).

The heating temperature sensor 7 and the interconnection portions 30e and 30h are originally formed of the same semiconductor thin film 26. However, since the heating temperature sensor 7 formed on the diaphragm 4 is thermally treated by the process of FIG. 5(g), the property of the resistor body is different between the interconnection portions 30e and 30h and the heating temperature sensor 7 located in the vicinity of the heating resistor body 5.

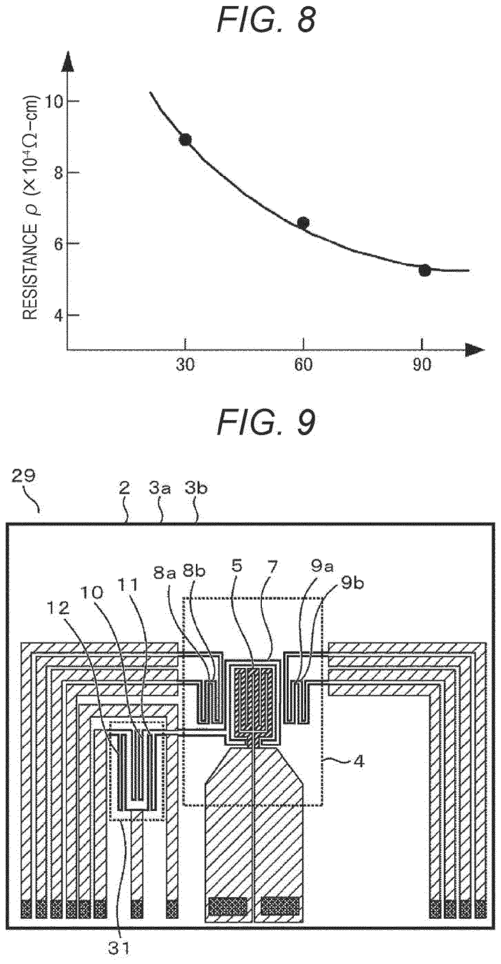

FIG. 7 illustrates the relation between the thermal treatment time and the resistance temperature coefficient when the resistor body using a polycrystalline Si thin film is thermally treated at a temperature of 900°C to 1000°C. Also, FIG. 8 illustrates the relation between the thermal treatment time and the specific resistance when the resistor body using a polycrystalline Si thin film is thermally treated at a temperature of 900°C to 1000°C. In FIG. 7, by applying a thermal treatment for a long time, the resistance temperature coefficient of the resistor body is improved. The resistance temperature coefficient of the heating temperature sensor 7 located on the diaphragm 4 is improved by the process of FIG. 5 (g). However, since the interconnection portions 30e and 30h are located outside the diaphragm which is a location that is not heated, the resistance temperature coefficient thereof is not changed. Therefore, the heating temperature sensor 7 has a higher resistance temperature coefficient than the interconnection portions 30e and 30h. Therefore, the resistance temperature coefficient of the heating temperature sensor 7 is improved by the process of FIG. 5(g), and the temperature detection sensitivity is improved. Thus, the temperature of the heating resistor body 5 can be detected with a high accuracy, and the temperature of the heating resistor body 5 can be controlled with a high accuracy. Accordingly, the flow detection accuracy is improved.

Also, in FIG. 8, by applying a more thermal treatment, the specific resistance of the resistor body is reduced. This is because the crystal grain size of the polycrystalline Si thin film is increased. The specific resistance of the heating temperature sensor 7 located on the diaphragm 4 is reduced by the process of FIG. 5(g). However, since the interconnection portions 30e and 30h are located outside the diaphragm which is a location that is not heated, the specific resistance thereof is not changed. Therefore, the heating temperature sensor 7 has a lower specific resistance than the interconnection portions 30e and 30h. When the thermal treatment time is increased, the specific resistance change is gradually reduced from the result of FIG. 8, so that there is a saturation characteristic at a point of a constant value. When the thermal treatment is performed for 90 minutes or more, the specific resistance change is nearly saturated. Therefore, even when a variation of several minutes occurs in the thermal treatment time, a variation in the specific resistance can be reduced. Also, the resistor body is stabilized by increasing the crystal grain size by the thermal treatment of 90 minutes or more. Thus, the resistance degradation can be reduced. Therefore, a highly-reliable thermal type flowmeter having a small property variation even in long-term operation is obtained.

The upstream side temperature sensors 8a and 8b and the downstream side temperature sensors 9a and 9b illustrated in FIG. 6 are the same as described above. The upstream side temperature sensors 8a and 8b on the diaphragm 4 are formed on the upstream side of the heating resistor body 5. Also, the upstream side temperature sensors 8a and 8b extend toward the upstream side of the diaphragm 4 and are wire-connected to interconnection portions 30a, 30b, 30c and 30d. The portions from the upstream side temperature sensors 8a and 8b to the interconnection portions 30a, 30b, 30c and 30d are formed by etching the semiconductor thin film 26 formed by the process of FIG. 5(b).

The upstream side temperature sensors 8a and 8b and the interconnection portions 30a, 30b, 30c and 30d are originally formed of the same semiconductor thin film 26. However, since the upstream side temperature sensors 8a and 8b formed on the diaphragm 4 are thermally treated by the process of FIG. 5(g), the property of the resistor body is different between the interconnection portions 30a, 30b, 30c and 30d and the upstream side temperature sensors 8a and 8b located in the vicinity of the heating resistor body 5. That is, the upstream side temperature sensors 8a and 8b have a higher resistance temperature coefficient than the interconnection portions 30a, 30b, 30c and 30d. Also, the upstream side temperature sensors 8a and 8b have a lower specific resistance than the interconnection portions 30a, 30b, 30c and 30d. This is the same for the downstream side temperature sensors 9a and 9b and interconnection portions 30k, 30l, 30m and 30n thereof.

Therefore, the resistance temperature coefficients of the upstream side temperature sensors 8a and 8b and the downstream side temperature sensors 9a and 9b are improved by the process of FIG. 5(g), and the temperature detection sensitivity is improved. Thus, the temperature difference between the upstream side and the downstream side of the heating resistor body 5 can be detected with a high accuracy, and high-accuracy flow detection is possible especially even in a small temperature difference of a low-flow region.

This is the same for the heating resistor body illustrated in FIG. 6.

According to this example, even when the sensor element and the semiconductor integrated circuit are provided on the substrate 2 formed of a semiconductor, the property of the sensor element is not degraded. Also, the compactness/high accuracy of the thermal type flowmeter can be implemented without causing the malfunction and the property variation of the semiconductor integrated circuit.

In this example, the diaphragm 4 is obtained by removing all of the substrate 2. However, the effect is obtained even when a portion of the substrate 2 is not removed.
That is, when the film thickness of the substrate 2 is different between the portion that is thermally treated and the portion that is not thermally treated, a partial high-temperature thermal treatment is possible and this can also be applied to the thermal treatment of other semiconductor elements, the sensor element, or the like.

### Second example

A second example will be described below.

A configuration of a sensor element 29 of a thermal type flowmeter according to this example will be described with reference to FIG. 9. In this example configurations different from the first example which is useful for understanding the invention will be described, and the other configurations are the same as the first example which is useful for understanding the invention.

FIG. 9 is a plan view illustrating the sensor element 29 according to this example. Also, FIG. 10 illustrates a cross-sectional view of the sensor element 1 illustrated in FIG. 9. Temperature-sensing resistor bodies 10, 11 and 12 having a resistance value changing according to the temperature of an air flow 6 are disposed on an electrical insulating film 3a outside a diaphragm 4. In this example a substrate 2 corresponding to a region, in which the temperature-sensing resistor bodies 10, 11 and 12 are formed, is removed. That is, a second diaphragm 31 is provided in addition to the diaphragm 4. The second diaphragm 31 is formed simultaneously with the diaphragm 4 in the process of FIG. 5(f).

The temperature-sensing resistor bodies 10, 11 and 12 formed on the diaphragm 31 are resistor bodies that constitute a bridge circuit and the heating temperature sensor 7 in the driving circuit illustrated in FIG. 3. By this bridge circuit, a heating resistor body 5 is heated to a predetermined temperature with respect to the temperature of air. Therefore, it is preferable that the heating temperature sensor 7 and the temperature-sensing resistor bodies 10, 11 and 12 have substantially the same resistance temperature coefficients. Thus, like the heating temperature sensor 7, it is preferable that the temperature-sensing resistor bodies 10, 11 and 12 is also thermally treated in the process of FIG. 5(g). Thus, the diaphragm 4 is provided by removing the substrate 2 of the region in which the temperature-sensing resistor bodies 10, 11 and 12 are formed, and the temperature-sensing resistor bodies 10, 11 and 12 are energized and heated to a higher temperature. Like the heating temperature sensor 7, by thermally treating the temperature-sensing resistor bodies 10, 11 and 12, the resistance temperature coefficient can be improved. Also, since a resistance change occurs depending on the temperature of the air, the temperature-sensing resistor bodies 10, 11 and 12 may be used as an intake air temperature sensor that detects the temperature of the air. In this case, the resistance temperature coefficient is improved by the thermal treatment process of FIG. 5(g), and the air temperature detection sensitivity is improved, thereby achieving high accuracy. Also, by forming the temperature-sensing resistor bodies 10, 11 and 12 on the diaphragm 31, the thermal capacity can be greatly reduced, and the response to an air temperature change can be improved. Also, since a one-chip complex sensor can be implemented by forming semiconductor integrated circuits serving as a driving circuit of an intake air temperature and an intake air flow on one semiconductor substrate, significant miniaturization can be implemented.

### Embodiment

The embodiment of the invention will be described below.

A configuration of a sensor element 32 of a thermal type flowmeter according to this embodiment will be described with reference to FIG. 11. In this embodiment, configurations different from the first example which is useful for understanding the invention will be described, and the other configurations are the same as the first example which is useful for understanding the invention.

FIG. 11 is a cross-sectional view illustrating the sensor element 32 according to this embodiment. In this embodiment, a thermal treatment heater 33 is formed through an electrical insulating film 3c under a heating resistor body 5, a heating temperature sensor 7, upstream side temperature sensors 8a and 8b, and downstream side temperature sensors 9a and 9b that are formed on a diaphragm 4. The thermal treatment heater can be formed in the same process as the heating resistor body 5, and specifically, a multilayer film can be formed by repeating the processes of FIGS. 5(b), 5(c) and 5(d). An electrode of the thermal treatment heater is extracted outside the diaphragm 4 by an interconnection portion 34, and an electrode pad portion 35 is formed. The interconnection portion 34 is formed of the same film as the thermal treatment heater. The electrode pad portion 35 is formed in the same manner as the electrode pad portion 13. In this embodiment, in the process of FIG. 5(g), the portion of the diaphragm 4 is heated to a high temperature by energizing and heating the thermal treatment heater 33, and the heating resistor body 5, the heating temperature sensor 7, the upstream side temperature sensors 8a and 8b, and the downstream side temperature sensors 9a and 9b are thermally treated. Specifically, in the process of FIG. 5(g), a probe 28 is brought into contact with the electrode pad portion 35 and a current from a power supply 27 is adjusted illustrated in FIG. 11, and a heating current is flowed through the thermal treatment heater 33.

By the above configuration, the region in which the thermal treatment heater 33 is formed can be widened, and the diaphragm 4 can be heated at a uniform temperature distribution. That is, the heating resistor body 5, the heating temperature sensor 7, the upstream side temperature sensors 8a and 8b, and the downstream side temperature sensors 9a and 9b can be thermally treated at the same temperature. In the first example, since a thermal treatment is performed by heating the heating resistor body 5, the temperature of the resistor body located outside in the diaphragm 4 is lowered, so that it cannot be heated to the optimal temperature. Thus, the temperatures of the upstream side temperature sensors 8a and 8b and the downstream side temperature sensors 9a and 9b are lowered, so that a sufficient thermal treatment cannot be implemented. According to this embodiment, the temperatures in the diaphragm 4 can be made uniform, and the upstream side temperature sensors 8a and 8b and the downstream side temperature sensors 9a and 9b located in the diaphragm 4 can be thermally treated at the optimal temperature. That is, as compared to the case of the first example, the resistance temperature coefficients of the upstream side temperature sensors 8a and 8b and the downstream side temperature sensors 9a and 9b are improved, and a high-accuracy thermal type flowmeter is obtained.

The thermal treatment heater 33 may be formed of a polycrystalline Si film as in the first example, or may be formed of other materials. For example, the thermal treatment heater 33 may be formed of metal materials such as platinum, tungsten, tantalum, and molybdenum that have an excellent heat resistance. When the thermal treatment heater 33 is formed of the metal materials, the thermal conductivity is increased, so that a more uniform temperature distribution can be achieved. Thus, the heating resistor body 5, the heating temperature sensor 7, the upstream side temperature sensors 8a and 8b, and the downstream side temperature sensors 9a and 9b can be simultaneously heated to the optimal temperature, and the thermal treatment can be performed more simply and easily.

In this embodiment, the thermal treatment heater is provided at the diaphragm 4 illustrated in the first example, but this may also be applied in the region in which the temperature-sensing resistor bodies 10, 11 and 12 illustrated in the first embodiment are formed. Specifically, the thermal treatment heater is formed through the electrical insulating film 3c under the temperature-sensing resistor bodies 10, 11 and 12. A diaphragm 31 is formed by removing a portion of a substrate 2 corresponding to a region in which the temperature-sensing resistor bodies 10, 11 and 12 are formed. Thereafter, the temperature-sensing resistor bodies 10, 11 and 12 are thermally treated by heating the thermal treatment heater.

Accordingly, the thermal treatment temperatures of the temperature-sensing resistor bodies 10, 11 and 12 are made uniform, so that the resistance temperature coefficients of the temperature-sensing resistor bodies 10, 11 and 12 can be made more consistent. Accordingly, a variation in the resistance balance of the bridge circuit including the heating temperature sensor 7 and the temperature-sensing resistor bodies 10, 11 and 12 is reduced, so that the temperature of the heating resistor body 5 can be controlled with a high accuracy.

### Third example

A third example will be described below.

A configuration of a sensor element 36 of a thermal type flowmeter according to this embodiment will be described with reference to FIG. 12. In this example configurations different from the first example which is useful for understanding the invention will be described, and the other configurations are the same as the first example which is useful for understanding the invention.

FIG. 12 is a cross-sectional view illustrating the sensor element 36 according to this example. In a substrate 2 forming the sensor element 36, a semiconductor integrated circuit 37 driving the sensor element and performing flow detection is provided integrally. Specifically, the semiconductor integrated circuit 37 includes the transistor 16, the amplifier 15, and the amplifier 17 that are illustrated in FIG. 3.

In the first example, as illustrated in FIG. 5(g), the heat treatment is performed by supplying a current to the electrode pad portion 13 from a power supply 27 through a probe 28. In this embodiment, a current is supplied to a heating resistor body 5 through the semiconductor integrated circuit 37. By providing an arithmetic device, a switch or the like in the semiconductor integrated circuit 37, the current supplied to the heating resistor body 5 can be controlled. Thus, as in the first example, it is not necessary to provide the electrode pad portion 13 for connection of the probe 28. Since it is not necessary to provide the electrode pad portion 13 for thermal treatment, the area of the sensor element 36 can be reduced.

FIG. 14 illustrates an example of the installation of the sensor element 36 by a mold material 40. The sensor element 36 is disposed on a lead frame 41, and a lead frame 43 and an electrode pad 45 formed in the sensor element 36 are connected by a bonding wire. The electrode pad 45 is provided with a power supply terminal for driving the sensor element 36, an output terminal for extracting a detected flow signal, and a communication terminal for digital communication with the semiconductor integrated circuit 37, and the like. The lead frame 43 is connected to a power supply of a thermal type flowmeter and a connector for extracting a signal to the outside.

The mold material 40 is formed of an epoxy-based resin and is manufactured by known injection molding. Also, the mold material 40 is formed to avoid a diaphragm 4 of the sensor element 36 such that the diaphragm 4 is exposed to air. Also, on the back side of the sensor element 36, a through-hole 42 is formed in the lead frame 41 and the mold material 40 such that the back side of the diaphragm 4 is not sealed up.

Since the injection molding can provide a small shape variation in the mold material and enables low-cost manufacturing, a variation in the installation of the sensor element can be reduced. Since the manufacturing variation is small, the size of the sensor element can be reduced.

### Another example

Another example will be described below.

In this embodiment, configurations different from the first example which is useful for understanding the invention will be described, and the other configurations are the same as the first example which is useful for understanding the invention.

The resistor bodies of the heating resistor body 5, the heating temperature sensor 7, the upstream side temperature sensors 8a and 8b, and the downstream side temperature sensors 9a and 9b are formed of polycrystalline Si in the first example, but they may also be formed of other materials.

The resistor body formed in the sensor element may be formed of semiconductor materials such as doped monocrystalline silicon and doped polycrystalline silicon, and metal materials such as platinum, tungsten, tantalum, and molybdenum. The resistance temperature coefficient of the metal materials is 2000 ppm/°C or more, and a high-sensitivity sensor element is obtained. Since platinum as the metal material starts crystal growth at 800°C or more, it requires a thermal treatment of 800°C or more. A resistor body with a good property is obtained by performing the thermal treatment preferably at 900°C. Also, since molybdenum starts crystal growth at 700°C or more, it requires a thermal treatment of 700°C or more. A resistor body with a high resistance temperature coefficient is obtained by performing the thermal treatment preferably at 1000°C.

Therefore, when the metal material is used, the thermal treatment temperature in the process illustrated in FIG. 5(g) is preferably 700°C or more. Specifically, in the case of platinum, the effect is obtained by performing the thermal treatment at 800°C or more. In the case of molybdenum, the effect is obtained by performing the thermal treatment at 700°C or more. Preferably, by performing the thermal treatment at 900°C or more in the case of platinum and at 1000°C or more in the case of molybdenum, a resistor body having a high resistance temperature coefficient and reducing the effect of a variation in the thermal treatment time is obtained. Also, a high-sensitivity thermal type flowmeter is obtained as compared to the case of using a polycrystalline Si thin film.

### Reference Signs List

1, 29, 32, 36 sensor element
2 substrate
3a, 3b, 3c electrical insulating film
4, 31 diaphragm
5 heating resistor body
6 air flow
7 heating temperature sensor
8a, 8b upstream temperature sensor
9a, 9b downstream temperature sensor
10, 11, 12 temperature-sensing resistor body
13, 35 electrode pad portion
14 temperature distribution
15, 17 amplifier
16 transistor
18 intake air pipe line
19 base member
20 intake air
21 sub-passage
22 circuit board
23 gold bonding wire
24 terminal
25 aluminum bonding wire
26 semiconductor thin film
27 power supply
28 probe
30, 30a to n, 34 interconnection portion
33 thermal treatment heater
37 semiconductor integrated circuit
39 ammeter
40 mold member
41, 43 lead frame
42 through-hole
44 bonding wire
45 electrode pad

## Claims

1. A method for manufacturing a thermal type flowmeter including a hollow portion which is formed in a semiconductor substrate (2), a thin film portion which is formed by insulating films (3a, 3b, 3c) provided to cover the hollow portion, a heating resistor body (5) and a temperature-measuring resistor body which are formed between the insulating films (3a, 3b),
**characterized in that**
a thermal treatment heater (33) is provided under the heating resistor body (5), wherein the thermal treatment heater (33) is separated from the heating resistor body (5) by an insulating film (3c),
and that a thermal treatment is performed to grow a crystal grain size of the heating resistor body (5) and a crystal grain size of the temperature-measuring resistor body by heating the thin film portion after forming the thin film portion by energizing the thermal treatment heater (33) .

2. The method according to claim 1, comprising:
a process of forming a second thin film portion on the semiconductor substrate (2),
wherein
a second temperature-measuring resistor body is formed in the second thin film portion, and
a thermal treatment is performed to grow a crystal grain size of the second temperature-measuring resistor body by heating the second thin film portion after forming the second thin film portion.

3. The method according to claim 2, wherein
a second thermal treatment heater is formed in the second thin film portion, and a thermal treatment is performed to grow a crystal grain size of the second heating resistor body by heating the second thin film portion by energizing the second thermal treatment heater.

4. A thermal type flowmeter including
a hollow portion which is formed in a semiconductor substrate (2),
a thin film portion which is formed by insulating films (3a, 3b) provided to cover the hollow portion,
a heating resistor body (5) and a temperature-measuring resistor body which are formed between the insulating films (3a, 3b), and
an interconnection portion (30) which is connected to the heating resistor body (5) and extends outside the thin film portion, wherein
a resistance temperature coefficient of a portion of the interconnection portion (30) located outside the thin film portion is smaller than a resistance temperature coefficient of the heating resistor body (5), and
a specific resistance of the portion of the interconnection portion (30) located outside the thin film portion is greater than a specific resistance of the heating resistor body (5),
the thermal type flowmeter **characterized by** a thermal treatment heater (33) provided under the heating resistor body (5), wherein
the thermal treatment heater (33) is separated from the heating resistor body (5) by an insulating film (3c).

5. The thermal type flowmeter according to claim 4, wherein the thermal treatment heater (33) is provided in the thin film portion, and an energization pad is provided to energize the thermal treatment heater (33).

6. The thermal type flowmeter according to claim 4, wherein
a second thin film portion is formed on the semiconductor substrate (2),
a second temperature-measuring resistor body is formed in the second thin film portion,
a second interconnection portion is connected to the second temperature-measuring resistor body and extends outside the second thin film portion,
a resistance temperature coefficient of a portion of the second interconnection portion located outside the second thin film portion is smaller than a resistance temperature coefficient of the second temperature-measuring resistor body, and
a specific resistance of the portion of the second interconnection portion located outside the second thin film portion is greater than a specific resistance of the second temperature-measuring resistor body.

7. The thermal type flowmeter according to claim 6, wherein
a second thermal treatment heater is formed in the second thin film portion,
a third interconnection portion is connected to the second thermal treatment heater and extends outside the second thin film portion,
a resistance temperature coefficient of a portion of the third interconnection portion located outside the second thin film portion is smaller than a resistance temperature coefficient of the second heating resistor body, and
a specific resistance of the portion of the third interconnection portion located outside the second thin film portion is greater than a specific resistance of the second thermal treatment heater.

8. The thermal type flowmeter according to any one of claims 4 to 7, wherein
an integrated circuit (37) including a semiconductor transistor. (16) which performs driving/detecting/signal processing is provided on the semiconductor substrate (2) .

9. The thermal type flowmeter according to claim 8, wherein
the semiconductor substrate (2) is disposed on a lead frame (41, 43), and
the semiconductor substrate (2) and the lead frame (41, 43) are molded by a mold member (40).

## Patentansprüche

1. Verfahren zum Herstellen eines Durchflussmessers des thermischen Typs, der einen hohlen Abschnitt, der in einem Halbleitersubstrat (2) gebildet ist, einen Dünnschichtabschnitt, der durch Isolierfilme (3a, 3b, 3c) gebildet ist, die dazu vorgesehen sind, den hohlen Abschnitt abzudecken, einen Wärmewiderstandskörper (5) und einen Temperaturmesswiderstandskörper, die zwischen den Isolierfilmen (3a, 3b) gebildet sind, umfasst, **dadurch gekennzeichnet, dass** eine Wärmebehandlungs-Heizeinrichtung (33) unter dem Wärmewiderstandskörper (5) vorgesehen ist, wobei die Wärmebehandlungs-Heizeinrichtung (33) von dem Wärmewiderstandskörper (5) durch einen Isolierfilm (3c) getrennt ist, und dass eine Wärmebehandlung ausgeführt wird, um eine Kristallkorngröße des Wärmewiderstandskörpers (5) und eine Kristallkorngröße des Temperaturmesswiderstandskörpers durch Erhitzen des Dünnschichtabschnitts nach dem Bilden des Dünnschichtabschnitts durch Versorgen der Wärmebehandlungs-Heizeinrichtung (33) mit Energie wachsen zu lassen.

2. Verfahren nach Anspruch 1, das Folgendes umfasst:
einen Prozess zum Bilden eines zweiten Dünnschichtabschnitts auf dem Halbleitersubstrat (2),
wobei
der zweite Temperaturmesswiderstandskörper in dem zweiten Dünnschichtabschnitt gebildet wird und
eine Wärmebehandlung ausgeführt wird, um eine Kristallkorngröße des zweiten Temperaturmesswiderstandskörpers durch Erwärmen des zweiten Dünnschichtabschnitts, nachdem der zweite Dünnschichtabschnitt gebildet worden ist, wachsen zu lassen.

3. Verfahren nach Anspruch 2, wobei
eine zweite Wärmebehandlungs-Heizeinrichtung in dem zweiten Dünnschichtabschnitt gebildet wird und eine Wärmebehandlung ausgeführt wird, um eine Kristallkorngröße des zweiten Heizwiderstandskörpers durch Erwärmen des zweiten Dünnschichtabschnitts, indem die zweite Wärmebehandlungs-Heizeinrichtung mit Energie versorgt wird, wachsen zu lassen.

4. Durchflussmesser des thermischen Typs, der Folgendes umfasst:
einen hohlen Abschnitt, der in einem Halbleitersubstrat (2) gebildet ist,
einen Dünnschichtabschnitt, der durch Isolierfilme (3a, 3b), die dazu vorgesehen sind, den hohlen Abschnitt abzudecken, gebildet ist,
einen Heizwiderstandskörper (5) und einen Temperaturmesswiderstandskörper, die zwischen den Isolierfilmen (3a, 3b) gebildet sind, und
einen Verbindungsabschnitt (30), der mit dem Heizwiderstandskörper (5) verbunden ist und sich außerhalb des Dünnschichtabschnitts erstreckt, wobei
der Widerstandstemperaturkoeffizient eines Abschnitts des Verbindungsabschnitts (30), der sich außerhalb des Dünnschichtabschnitts befindet, kleiner als ein Widerstandstemperaturkoeffizient des Heizwiderstandskörpers (5) ist, und
ein spezifischer Widerstand des Abschnitts des Verbindungsabschnitts (30), der sich außerhalb des Dünnschichtabschnitts befindet, größer als ein spezifischer Widerstand des Heizwiderstandskörpers (5) ist,
wobei der Durchflussmesser des thermischen Typs **gekennzeichnet ist durch** eine Wärmebehandlungs-Heizeinrichtung (33), die unter dem Heizwiderstandskörper (5) vorgesehen ist, wobei
die Wärmebehandlungs-Heizeinrichtung (33) von dem Heizwiderstandskörper (5) durch einen Isolierfilm (3c) getrennt ist.

5. Durchflussmesser des thermischen Typs nach Anspruch 4, wobei
die Wärmebehandlungs-Heizeinrichtung (33) in dem Dünnschichtabschnitt vorgesehen ist und eine Energieversorgungsanschlussfläche vorgesehen ist, um die Wärmebehandlungs-Heizeinrichtung (33) mit Energie zu versorgen.

6. Durchflussmesser des thermischen Typs nach Anspruch 4, wobei
ein zweiter Dünnschichtabschnitt auf dem Halbleitersubstrat (2) gebildet ist,
ein zweiter Temperaturmesswiderstandskörper in dem zweiten Dünnschichtabschnitt gebildet ist,
ein zweiter Verbindungsabschnitt mit dem zweiten Temperaturmesswiderstandskörper verbunden ist und sich außerhalb des zweiten Dünnschichtabschnitts erstreckt,
ein Widerstandstemperaturkoeffizient eines Abschnitts des zweiten Verbindungsabschnitts, der sich außerhalb des zweiten Dünnschichtabschnitts erstreckt, kleiner als ein Widerstandstemperaturkoeffizient des zweiten Temperaturmesswiderstandskörpers ist, und
ein spezifischer Widerstand des Abschnitts des zweiten Verbindungsabschnitts, der sich außerhalb des zweiten Dünnschichtabschnitts befindet, größer als ein spezifischer Widerstand des zweiten Temperaturmesswiderstandskörpers ist.

7. Durchflussmesser des thermischen Typs nach Anspruchs 6, wobei
eine zweite Wärmebehandlungs-Heizeinrichtung in dem zweiten Dünnschichtabschnitt gebildet ist,
ein dritter Verbindungsabschnitt mit der zweiten Wärmebehandlungs-Heizeinrichtung verbunden ist und sich außerhalb des zweiten Dünnschichtabschnitts erstreckt,
ein Widerstandstemperaturkoeffizient eines Abschnitts des dritten Verbindungsabschnitts, der sich außerhalb des zweiten Dünnschichtabschnitts erstreckt, kleiner als ein Widerstandstemperaturkoeffizient des zweiten Heizwiderstandskörpers ist, und
ein spezifischer Widerstand des Abschnitts des dritten Verbindungsabschnitts, der sich außerhalb des zweiten Dünnschichtabschnitts erstreckt, größer als ein spezifischer Widerstand der zweiten Wärmebehandlungs-Heizeinrichtung ist.

8. Durchflussmesser des thermischen Typs nach einem der Ansprüche 4 bis 7, wobei
auf dem Halbleitersubstrat (2) eine integrierte Schaltung (37) vorgesehen ist, die einen Halbleitertransistor (16) enthält, der eine Ansteuerungs-/Detektions-/Signalverarbeitung ausführt.

9. Durchflussmesser des thermischen Typs nach Anspruch 8, wobei
das Halbleitersubstrat (2) auf einem Leiterrahmen (41, 43) angeordnet ist und
das Halbleitersubstrat (2) und der Leiterrahmen (41, 43) durch ein Gießelement (40) vergossen sind.

## Revendications

1. Procédé pour fabriquer un débitmètre du type thermique incluant une portion creuse qui est formée dans un substrat semi-conducteur (2), une portion en film mince qui est formée par des films isolants (3a, 3b, 3c) prévus pour couvrir la portion creuse, un corps de résistance de chauffage (5), et un corps de résistance de mesure de température qui sont formés entre les films isolants (3a, 3b),
**caractérisé en ce qu'**un élément chauffant de traitement thermique (33) est prévu au-dessous du corps de résistance de chauffage (5), dans lequel l'élément chauffant de traitement thermique (33) est séparé du corps de résistance de chauffage (5) par un film isolant (3c), et
**en ce qu'**un traitement thermique est effectué pour faire croître une taille des grains de cristaux du corps de résistance de chauffage (5) et une taille des grains de cristaux du corps de résistance de mesure de température en chauffant la portion en film mince après avoir formé la portion en film mince en fournissant de l'énergie à l'élément chauffant de traitement thermique (33).

2. Procédé selon la revendication 1, comprenant :
un processus consistant à former une seconde portion en film mince sur le substrat semi-conducteur (2), et dans lequel
un second corps de résistance de mesure de température est formé dans la seconde portion en film mince, et
un traitement thermique est effectué pour faire croître une taille des grains de cristaux du second corps de résistance de mesure de température en chauffant la seconde portion en film mince après avoir formé la seconde portion en film mince.

3. Procédé selon la revendication 2, dans lequel
un second élément chauffant de traitement thermique est formé dans la seconde portion en film mince, et un traitement thermique est effectué pour faire croire une taille des grains de cristaux du second corps de résistance de chauffage en chauffant la seconde portion en film mince en fournissant de l'énergie au second élément chauffant de traitement thermique.

4. Débitmètre du type thermique incluant
une portion creuse qui est formée dans un substrat semi-conducteur (2), une portion en film mince qui est formée par des films isolants (3a, 3b) prévus pour couvrir la portion creuse,
un corps de résistance de chauffage (5) et un corps de résistance de mesure de températures qui sont formés entre les films isolants (3a, 3b), et une portion d'interconnexion (30) qui est connectée au corps de résistance de chauffage (5) et qui s'étend à l'extérieur de la portion en film mince, dans lequel
un coefficient de température de résistance d'une portion de la portion d'interconnexion (30) située à l'extérieur de la portion en film mince est plus faible qu'un coefficient de température de résistance du corps de résistance de chauffage (5), et
une résistance spécifique de la portion de la portion d'interconnexion (30) située à l'extérieur de la portion en film mince est supérieure à une résistance spécifique du corps de résistance de chauffage (5),
le débitmètre de type thermique étant **caractérisé par** un élément chauffant de traitement thermique (33) prévu au-dessous du corps de résistance de chauffage (5), dans lequel
l'élément chauffant de traitement thermique (33) est séparé du corps de résistance de chauffage (5) par un film isolant (3c).

5. Débitmètre de type thermique selon la revendication 4, dans lequel l'élément chauffant de traitement thermique (33) est prévu dans la portion en film mince, et un patin de fourniture d'énergie est prévu pour fournir de l'énergie à l'élément chauffant de traitement thermique (33).

6. Débitmètre de type thermique selon la revendication 4, dans lequel
une seconde portion en film mince est formée sur le substrat semi-conducteur (2),
un second corps de résistance de mesure de température est formé dans la seconde portion en film mince,
une seconde portion d'interconnexion est connectée au second corps de résistance de mesure de température et s'étend à l'extérieur de la seconde portion en film mince,
un coefficient de température de résistance d'une portion de la seconde portion d'interconnexion située à l'extérieur de la seconde portion en film mince est plus faible qu'un coefficient de température de résistance du second corps de résistance de mesure de température, et
une résistance spécifique de la portion de la seconde portion d'interconnexion située à l'extérieur de la seconde portion en film mince est supérieure à une résistance spécifique du second corps de résistance de mesure de température.

7. Débitmètre de type thermique selon la revendication 6, dans lequel
un second élément chauffant de traitement thermique est formé dans la seconde portion en film mince,
une troisième portion d'interconnexion est connectée au second élément chauffant de traitement thermique et s'étend à l'extérieur de la seconde portion en film mince,
un coefficient de température de résistance d'une portion de la troisième portion d'interconnexion située à l'extérieur de la seconde portion en film mince est plus faible qu'un coefficient de température de résistance du second corps de résistance de chauffage, et
une résistance spécifique de la portion de la troisième portion d'interconnexion située à l'extérieur de la seconde portion en film mince est supérieure à une résistance spécifique du second élément chauffant de traitement thermique.

8. Débitmètre de type thermique selon l'une quelconque des revendications 4 à 7, dans lequel
un circuit intégré (37) incluant un transistor semi-conducteur (16) qui effectue des opérations de pilotage, détection, traitement de signaux est prévu sur le substrat semi-conducteur (2).

9. Débitmètre de type thermique selon la revendication 8, dans lequel
le substrat semi-conducteur (2) est disposé sur un cadre conducteur (41, 43), et
le substrat semi-conducteur (2) et le cadre conducteur (41, 43) sont moulés par un élément de moulage (40).
